# EUROPÄISCHE PATENTSCHRIFT

(11) **EP 2 532 125 B1**
(45) Veröffentlichungstag und Bekanntmachung des Hinweises auf die Patenterteilung: **08.07.2015**
(21) Anmeldenummer: 11705172.2
(22) Anmeldetag: 01.02.2011
(51) Int. Cl.: H04L 12/403, H04L 12/40

(54) **Verfahren für ein schnelles Sensorsystem**
Method for a fast sensor system
Procédé pour système de capteurs rapide

(30) Priorität: 01.02.2010 DE 102010006621
(43) Veröffentlichungstag der Anmeldung: 12.12.2012
(73) Patentinhaber: Huf Hülsbeck & Fürst GmbH & Co. KG, 42551 Velbert (DE)
(72) Erfinder: VAN GASTEL, Peter, 42699 Solingen (DE)
(74) Vertreter: Bals, Rüdiger
(86) Internationale Anmeldenummer: PCT/EP2011/051361
(87) Internationale Veröffentlichungsnummer: WO 2011/092340

(56) Entgegenhaltungen:
- EP-A1- 2 079 176
- EP-A2- 1 781 061
- DE-A1- 10 310 622

## Beschreibung

Die vorliegende Erfindung ist auf ein Verfahren zur Steuerung eines Sensorsystems für ein Fahrzeug gemäß des Oberbegriffs von Anspruch 1 gerichtet. Ein derartiges Sensorsystem weist zumindest zwei Sensoren auf, die jeweils Detektionsbereiche innehaben und Änderungen in diesen Detektionsbereichen messtechnisch erfassen und als Messsignale weitergeben. Ferner enthält das Sensorsystem eine Steuereinheit, insbesondere in Form eines Mikroprozessors, die mit den Sensoren verbunden ist, wobei die Steuereinheit in die jeweiligen Messsignale auswertet und daraus zumindest ein Steuersignal generiert. Darüber hinaus enthält das Sensorsystem wenigstens einen Speicher, in dem zumindest das letzte Steuersignal gespeichert wird. Auch ist eine Schnittstelle in dem Sensorsystem vorgesehen, womit die Steuereinheit zumindest das letzte Steuersignal an ein externes Steuermodul weiterleitet.

Gattungsgemäße Sensorsysteme werden häufig in einem Fahrzeug, insbesondere Kraftfahrzeug, über ein Kommunikationssystem mit einem externen Steuermodul verbunden. Diese Kommunikationssysteme weisen in der Regel einen seriellen Datentransfer auf. Hierbei kann es sich im Fahrzeug um einen so genannten Local Interconnect Network (LiN-Bus) oder ein Controller Area Network (Can-Bus) handeln. Ein Problem bei diesen Kommunikationssystemen besteht darin, dass diese zeitlich willkürlich die einzelne Kommunikationsteilnehmer (hier: die Sensorsysteme) auf ihren Zustand hin abfragen, wozu sie jedoch dem Teilnehmer nur eine kurze Antwortzeit für das Antwortsignal einräumen. Sofern der Teilnehmer nicht rechtzeitig antwortet, kann somit eine Fehlermeldung generiert werden, die dem externen Steuermodul anzeigt, dass der entsprechende Teilnehmer fehlerbehaftet oder defekt ist. Allerdings benötigen einzelne Teilnehmer, wie z. B. das oben genannte Sensorsystem, ausreichend Zeit, um eine exakte Messung durchführen zu können. Wenn jedoch während dieser Messung das externe Steuermodul nach einem Antwortsignal anfragt, kommt es zu einer zeitlichen Verzögerung, die zu einem Fehler oder einer Störung führt, da eben die gattungsgemäßen Sensorsysteme die laufende Messung nicht unterbrechen können.

Das Dokument EP2079176 beschreibt ein Verfahren zur Übertragung der Daten zwischen Sensoren und einer Steuereinheit, wobei die Steuereinheit die jeweiligen Messsignale auswertet und daraus zumindest ein Steuersignal generiert, wenigstens einem Speicher, in dem zumindest das letzte Steuersignal gespeichert wird, einer Schnittstelle, womit die Steuereinheit zumindest das letzte Steuersignal an ein externes Steuermodul weiterleitet.

Somit ist es Aufgabe der vorliegenden Erfindung, ein Verfahren zur Steuerung eines Sensorsystems sowie ein entsprechendes Sensorsystem selber bereitzustellen, welches eine hohe Betriebssicherheit aufweist. Insbesondere sollen Anfragen eines externen Steuermoduls kurzfristig beantwortet werden, um etwaige Fehlermeldungen zu vermeiden.

Die vorliegende Aufgabe wird durch die Merkmale des erfindungsgemäßen Verfahrens, insbesondere aus dem kennzeichnenden Teil, von Anspruch 1 gelöst. Ebenfalls wird die Aufgabe durch das erfindungsgemäße Sensorsystem aus dem Anspruch 11 gelöst. Vorteilhafte Ausgestaltungen der Erfindung ergeben sich aus den abhängigen Unteransprüchen.

Bei dem erfindungsgemäßen Verfahren ist es vorgesehen, dass zumindest ein Messsignal eines Sensors in mehreren Messschritten von der Steuereinheit erfasst wird, und dass die Steuereinheit zwischen den einzelnen Messschritten zumindest das letzte Steuersignal über die Schnittstelle an das externe Steuermodul sendet. Folglich wird ein Messsignal eines Sensors nicht vollständig von der Steuereinheit erfasst, da hierfür die Zeit nicht ausreicht. Sollte nämlich in der Zwischenzeit das externe Steuermodul durch ein Anforderungssignal um ein Antwortsignal bitten, so ist die Steuereinheit nicht in der Lage, dieses Anforderungssignal des externen Steuermoduls durch ein Antwortsignal zu beantworten. Die Steuereinheit kann nämlich nur ein Messsignal eines Sensors gleichzeitig erfassen. Somit ist die Steuereinheit nicht in der Lage, gleichzeitig mehrere Aktoren, insbesondere in Form der Sensoren oder der Schnittstelle oder dergleichen, abzufragen bzw. die entsprechenden Signale zu erfassen. Durch die erfindungsgemäße Zerlegung des vollständigen Messsignals eines Sensors in mehrere kleinere Messschritte wird die Zeitdauer des einzelnen Messschrittes reduziert, so dass die Steuereinheit nach einem durchgeführten Messschritt frei ist für eine neue Aktion. Somit wird sichergestellt, dass die Steuereinheit auch schnell genug auf ein Anforderungssignal des externen Steuermoduls reagieren kann und ein entsprechendes Antwortsignal über die Schnittstelle an das externe Steuermodul weiterleitet. Dieses Antwortsignal kann zumindest das letzte zwischengespeicherte Steuersignal, welches in dem Speicher hinterlegt ist, umfassen. Folglich können durch die Unterteilung der langwierig dauernden Messsignalerfassung trotzdem sicher Fehlermeldungen und ausbleibende Antworten an das externe Steuermodul verhindert werden. Damit lässt sich die Betriebssicherheit des Sensorsystems deutlich erhöhen. Das erfindungsgemäße Verfahren ist auch mit einem Sensorsystem mit nur einem Sensor möglich und somit nicht auf zwei oder mehrere Sensoren beschränkt. Selbstverständlich muss dann das Messsignal des einzigen Sensors ebenfalls in mehrere Messschritte unterteilt werden.

Während des zeitlichen Zwischenraums zwischen der Beendigung eines vorausgehenden Messschrittes und dem Beginn des nachfolgenden Messschrittes kann die Steuereinheit regelmäßig die Schnittstelle nach einem Anforderungssignal abfragen. Sofern dieses Anforderungssignal nicht vorliegt, erfasst die Steuereinheit den nachfolgenden Messschritt, um somit ein vollständiges Messsignal von zumindest einem Sensor zu erhalten.

Ebenfalls kann es vorgesehen sein, dass jedes Messsignal der Sensoren in einzelne Messschritte unterteilt wird, die von der Steuereinheit erfasst werden. Diese Unterteilung ist besonders dann erforderlich, wenn die Erfassung des Messsignals besonders zeitaufwendig ist. Wenn jedoch ein Sensor des Sensorsystems in der Lage ist, auch kurzfristig ein vollständiges Messsignal an die Steuereinheit zu liefern, ist eine derartige Unterteilung nicht unbedingt erforderlich. Bei dem vorliegenden Verfahren kann somit für jeden einzelnen Sensor entschieden werden, inwieweit sein Messsignal in einzelne Messschritte unterteilt werden kann bzw. werden muss.

Darüber hinaus können einzelne Messschritte der jeweiligen Sensoren immer in einer vordefinierten Reihenfolge von der Steuereinheit erfasst werden, so dass die Steuereinheit die Sensoren der Reihe nach abfragt. Somit lässt sich das Sensorsystem an die unterschiedlichsten Sensoren und Aufgabestellungen im Fahrzeugbereich unproblematisch anpassen. Um jedoch den Speicherbedarf bei dem Sensorsystem so gering wie möglich zu halten, empfiehlt es sich, zunächst die einzelnen Messschritte für ein Messsignal (eines Sensors) der Reihe nach abzufragen, bis dieses vollständig vorliegt. Das Ergebnis des Messsignals kann dann in einem Speicher zwischengespeichert werden. Anschließend kann die Steuereinheit mit der Erfassung des nächsten Messsignals von einem weiteren Sensor beginnen, wenn zwischenzeitlich kein Anforderungssignal von dem externen Steuermodul vorliegt.

Um eine exakte Erfassung des vollständigen Messsignals eines Sensors vornehmen zu können, kann es vorgesehen sein, dass ein Messschritt (des Sensors) an einem definierten Punkt des Messsignals beendet wird und insbesondere bei dem nachfolgenden Messschritt (des Sensors) an diesem definierten Punkt die Auswertung bzw. Erfassung des Messsignals fortgesetzt wird. Durch die Vordefinierte Unterbrechung bei der Erfassung des Messsignals an einem definierten Punkt können somit sicher Messfehler bei der Erfassung des Messsignals vermieden werden. Außerdem kann somit das komplette Messsignal eines Sensors in fast beliebig viele Messschritte unterteilt werden, da diese nur davon abhängig sind, wo die definierten Punkte zur Unterbrechung des Messsignals vorgesehen sind.

Um auf jeden Fall sicherzustellen, dass das externe Steuermodul immer rechtzeitig ein Antwortsignal erhält, kann es vorgesehen sein, dass die Zeitspanne für einen Messschritt kleiner ist als eine vorgegebene Antwortzeitspanne von dem externen Steuermodul. Hierbei kann ferner die Steuereinheit nach einem bzw. nach jedem Messschritt überprüfen, ob der Schnittstelle ein Anforderungssignal des externen Steuermoduls für ein Antwortsignal vorliegt. Da die Antwortzeitspanne auf jeden Fall größer ist als die Zeitspanne für die einzelnen Messschritte, werden somit die Messschritte immer vorher beendet, bevor die Antwortzeitspanne abläuft. Damit bleibt der Steuereinheit genügend Zeit, die Schnittstelle nach einem angeforderten Antwortsignal bzw. Anforderungssignal abzufragen.

Um den Verfahrensablauf bei dem erfindungsgemäßen Verfahren möglichst zu vereinfachen, ist es denkbar, dass die Zeitspanne der Messschritte für alle Sensoren gleich lang ausgestaltet ist. Die Zeitspanne der Messschritte kann beispielsweise zwischen 2 bis 20 mal kleiner sein als die gesamte benötigte Zeitdauer für die Erfassung eines vollständigen Messsignals. Um jedoch nicht zu viele Messschritte für ein Messsignal vorzusehen, sollte die Zeitspanne z. B. nicht viel kleiner sein als ein fünftel der vorgegebenen Antwortzeitspanne für das externe Steuermodul. Ansonsten wird es auch schwierig, dass vollständige Messsignal in einer vernünftigen Zeitspanne zu erfassen, da die Steuereinheit zu sehr damit beschäftigt ist, zwischen den einzelnen Aktoren hin- und her zu springen. Durch dieses Hin- und Herspringen vergeht jedes mal auch eine gewisse Zeit, die sich bei so vielen Wechseln deutlich aufaddiert, was sich nachteilig auswirken kann.

Bei dem erfindungsgemäßen Verfahren kann es ferner vorgesehen sein, dass die Steuereinheit immer nur einen Aktor, insbesondere in Form der Sensoren oder der Schnittstelle, gleichzeitig abfragen bzw. erfassen kann. Sofern man mehrere Sensoren gleichzeitig abfragen möchte, müssen mehrere Mikroprozessoren, für die Steuereinheit vorgesehen sein, wodurch der Preis des Sensorsystems deutlich steigt und der Verfahrensablauf überproportional kompliziert ausgestaltet wird. Auch wird es schwierig, die Steuereinheit mit ihren Mikroprozessoren umzuprogrammieren, da man nicht nur die Fahrzeuggegebenheiten bzw. die Spezifikationen des externen Steuermoduls berücksichtigen muss, sondern auch den Schaltungsaufbau des Sensorsystems. Damit sein Datenaustausch nicht nur einseitig von dem Sensorsystem über die Schnittstelle zum externen Steuermodul stattfindet, kann es vorgesehen sein, dass eine bidirektionale Datenübertragung, insbesondere serielle Datenübertragung, über die Schnittstelle mit dem externen Steuermodul erfolgt. Selbstverständlich ist es auch denkbar, eine parallele Datenübertragung vorzunehmen, wozu jedoch mehrere Datenleitungen zwischen dem Sensorsystem und dem externen Steuermodul erforderlich sind. Will man jedoch den Verkabelungsaufwand im Fahrzeug so gering wie möglich halten, empfiehlt es sich eine serielle Datenübertragung zu wählen.

In dem erfindungsgemäßen Verfahren kann es auch vorgesehen sein, dass die Schnittstelle der Steuereinheit das Steuersignal als Antwortsignal an ein insbesondere serielles Kommunikationssystem, insbesondere ein so genanntes Local Interconnect Network (UN-Bus) oder ein Controller Area Networt (CAN-Bus) weitergibt. Die beiden zuletzt genannten Bussysteme (LIN- und CAN-Bussysteme) haben sich als quasi Standard in der Kraftfahrzeugelektronik herauskristallisiert. Dabei zeichnen sie sich durch ihren einfachen und stabilen Aufbau aus, der einer sicheren Datenübertragung zwischen den einzelnen Kommunikationsteilnehmern ermöglicht.

Ebenfalls ist die vorliegende Erfindung auch auf ein Sensorsystem für ein Fahrzeug gemäß des Anspruches 11 gerichtet. Bei diesem Sensorsystem ist es vorgesehen, dass in der Steuereinheit das erfindungsgemäße Verfahren nach den Ansprüche 1 bis 10 abläuft. Dabei kann optional vorgesehen sein, dass die Steuereinheit genau einen Mikroprozessor aufweist. Durch die Verwendung von nur einem Mikroprozessor lässt sich das Sensorsystem kostengünstig und trotzdem höchst flexibel einsetzen.

Bei dem vorliegenden Sensorsystem können die Sensoren als berührungslose Sensoren ausgestaltet sein, die insbesondere als Kapazitätssensoren aufgebaut sind. Gerade bei diesen Kapazitätssensoren ist eine schnelle Signalerfassung nicht oder nur sehr schwer möglich, da die vorhandene Kapazität des jeweiligen Kapazitätssensors messtechnisch erfasst werden muss und als Messsignal an die Steuereinheit weitergegeben wird. Ebenfalls ist es denkbar, dass mehr als zwei Sensoren zum Einsatz kommen. Diese können alle Kapazitätssensoren umfassen, wobei jedoch auch andere Sensorentypen, z.B. Piezosensoren, Ultraschallsensoren, Schaltelemente oder dergleichen denkbar sind. Auch spielt es im Sinne der vorliegenden Erfindung keine Rolle, ob der erste Sensor unter dem zweiten Sensor am Fahrzeug angebracht ist oder nicht. Somit kann auch der erste Sensor mit dem zweiten Sensor in dem vorliegenden Ausführungsbeispiel vertauscht werden.

Bei den berührungslosen Sensoren, kann es sich um Kapazitätssensoren oder Ultraschallsensoren handeln. Ebenfalls können auch andere Annäherungssensoren zum - Einsatz kommen. Vorteilhafterweise werden Kapazitätssensoren verwendet, da diese sicher und geschützt hinter einer Verkleidung angeordnet werden können, und nicht im direkten Kontakt zur Umwelt des Fahrzeugs stehen müssen.

Mit dem vorliegenden Sensorsystem kann ein virtueller Schalter z. B. zur Betätigung eines beweglichen Teils, insbesondere in Form einer Heckklappe, einer Seiten- oder Schiebetür, bei einem Fahrzeug realisiert werden.

Merkmale und Details, die im Zusammenhang mit dem erfindungsgemäßen Verfahren beschrieben sind, gelten dabei selbstverständlich auch im Zusammenhang mit dem erfindungsgemäßen Sensorsystem und umgekehrt.

Weitere, die Erfindung verbessernde Maßnahmen und Merkmale werden nachstehend gemeinsam mit der Beschreibung von bevorzugten Ausführungsbeispielen der Erfindung anhand der Figuren näher dargestellt. Es zeigen:
- Figur 1: ein Ausführungsbeispiel des zum erfindungsgemäßen Sensorsystem zum berührungslosen Betätigen einer Heckklappe an einem Fahrzeug,
- Figur 2: ein konkretes Ausführungsbeispiel zur Betätigung des Sensorsystems durch ein Bein oder einen Fuß einer Person,
- Figur 3: eine schematische Draufsicht der Anordnung von zwei Sensoren des Sensorsystems innerhalb eines hinteren Stoßfängers eines Fahrzeuges,
- Figur 4: eine schematische Darstellung des erfindungsgemäßen Sensorsystems mit der Anbindung an ein externes Steuermodul,
- Figur 5: schematische Darstellung der Unterteilung eines vollständigen Messsignals des ersten Sensors in mehrere Messschritte in einem Zeitdiagramm,
- Figur 6: zeitliches Ablaufdiagramm für die einzelnen Messsignale der Sensoren ohne ein Anforderungssignal des externen Steuermoduls,
- Figur 7: ein vergleichbares Ablaufdiagramm aus Figur 7, jedoch mit einem Anforderungssignal des externen Steuermoduls,
- Figur 8: vergleichbares Ablaufdiagramm zu Figur 6, bei dem jedoch die einzelnen Messschritte der Sensoren der Reihe nach erfasst werden, ohne dass ein Anforderungssignal des externen Steuermoduls vorliegt und
- Figur 9: vergleichbares Ablaufdiagramm zu Figur 8, mit einem Anforderungssignal zwischen der Erfassung des ersten Messsignals.

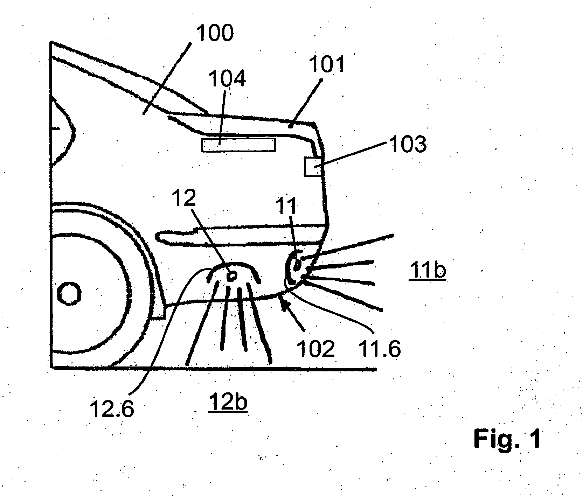

Figur 1 zeigt ein Ausführungsbeispiel des erfindungsgemäßen Sensorsystems 10 beispielsweise zum berührungslosen Betätigen einer Heckklappe 101 als bewegliches Teil 101 eines Fahrzeugs 100, welches ein Kraftfahrzeug darstellt. Das bewegliche Teil 101 wird durch ein elektromechanisches Schloss 103 in der Schließstellung gehalten und gesichert. Das Sensorsystem 10 umfasst einen ersten Sensor 11 zur Detektion eines Objektes 80 in einem ersten Detektionsbereich 11 b und einen zweiten Sensor 12 zur Detektion eines Objektes 80 in einem zweiten Detektionsbereich 12b. Die Sensoren 11 und 12 sind als Kapazitätssensoren 11 und 12 ausgebildet und in der Ansicht lediglich schematisch angedeutet. Der Detektionsbereich 11 b deckt den horizontalen Bereich hinter dem hinteren Stoßfänger 102 des Fahrzeugs 100 ab. Hingegen deckt der Detektionsbereich 12b den unteren Bereich unterhalb des hinteren Stoßfängers 102 ab. Damit ist ein erster Detektionsbereich 11b und ein zweiter Detektionsbereich 12b geschaffen, die beispielsweise geometrisch voneinander getrennt sind und keinen gemeinsamen Bereich außenseitig vom hinteren Stoßfänger 16 umfassen. Selbstverständlich können sich grundsätzlich die Detektionsbereiche 11 b, 12b auch teilweise überlappen. Die Detektionsbereiche 11b und 12b sind in den Figuren durch Strahlen angedeutet, die jedoch lediglich Bereiche andeuten, in denen eine Änderung der Dielektrizitätskonstante zwischen den Kapazitätssensoren 11 und 12 sowie der Umgebung des hinteren Stoßfängers 102 beschreiben. Diese Änderung der Dielektrizitätskonstante bewirkt eine Änderung der auf den Elektroden der Kapazitätssensoren 11 und 12 speicherbaren Ladung, die von dem Sensorsystem 10 detektiert werden kann. Damit kann durch die Kapazitätssensoren 11 und 12 das Vorhandensein eines Objektes 80, insbesondere das Vorhandensein von Körperteilen 80.1, 80.2 einer Person bei minimalem Stromverbrauch bereitgestellt werden.

Hinter den Kapazitätssensoren 11 und 12 erstrecken sich Richtmittel 11.6 und 12.6, die in Gestalt metallischer Abschirmungen 11.6, 12.6 ausgerührt sind und die die Kapazitätssensoren 11, 12 bogenartig oder halbschalenartig umschließen. Durch die Abschirmungen 11.6 und 12.6 wird sowohl der jeweilige Detektionsbereich 11 b und 12b vorgegeben, wobei eine verbesserte Trennung der Detektionsbereiche 11 b und 12b voneinander ermöglicht wird. Die metallische Abschirmungen 11.6 und 12.6 weisen das gleiche elektrische Potential auf wie die entsprechenden Kapazitätssensoren 11 und 12. Somit handelt es sich hierbei um sogenannte "Active Shields". Hinter diesen "Active Shields" können zusätzlich Masseelektroden bzw. Masseabschirmungen vorgesehen sein, womit die Detektionsbereiche 11 b, 12b der Kapazitätssensoren 11 und 12 in die umgekehrte Richtung zu den Masseabschirmungen gerichtet werden, d. h. von den Masseabschirmungen weg. Die Masseelektroden sind in der Regel direkt über einen Massekontakt mit der Fahrzeugmasse verbunden.

Selbstverständlich kann anstelle einer Heckklappe 101 auch eine Seiten- oder Schiebetür 101 durch das Sensorsystem 10 betätigt werden, welches als virtueller Schalter dienen kann. Hierbei sind die beiden Kapazitätssensoren 11, 12 beispielsweise im Türschwellerbereich angeordnet und vergleichbar zur erwähnten Stoßstange 102 im Heckbereich 106 ausgerichtet. Optional können die beiden Kapazitätssensoren 11 und 12 auch im unteren Bereich der Seitentür, vorzugsweise unter einem Steinschlagschutz, angeordnet sein. Eine Annäherung des Objektes 80 an die Seitentür 101 kann durch den ersten Kapazitätssensoren 11 oder einen Annäherungssensor für ein Zugangsberechtigungssystem, der in der Regel im Türgriff angeordnet ist, ermittelt werden.

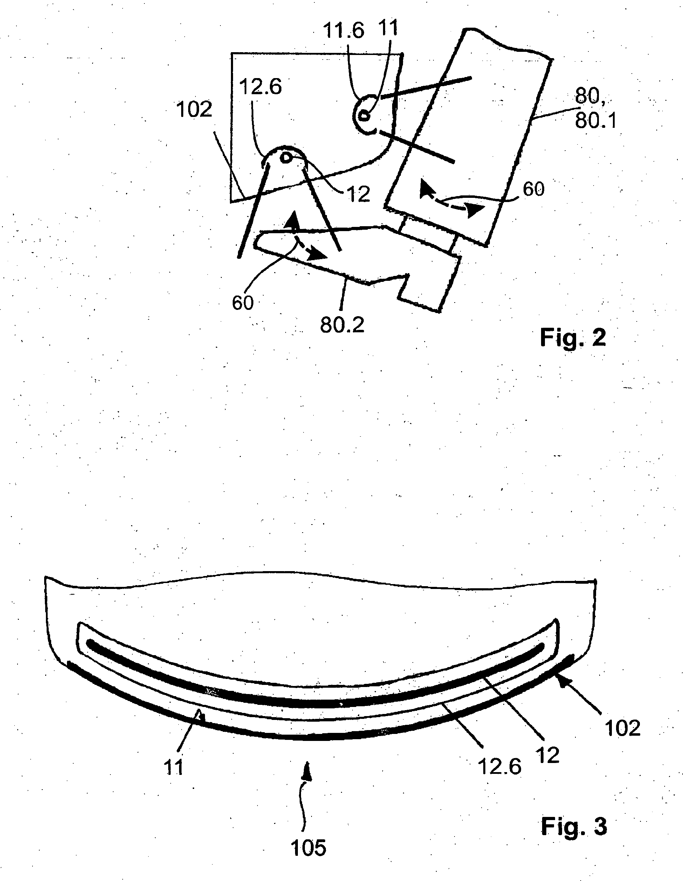

In Figur 2 ist in einer Seitenansicht ein Ausschnitt des hinteren Stoßfängers 102 bzw. des unteren Bereiches der Seitentür 101 gezeigt, in dem die Kapazitätssensoren 11, 12 mit den jeweiligen Abschirmungen 11.6, 12.6 eingebracht sind. Gemäß der Darstellung ist ein Bein 80.1 einer Person teilweise gezeigt und ragt in den horizontal verlaufenden ersten Detektionsbereich 11b hinein. Der sich an das Bein 80.1 anschließende Fuß 80.2 ragt hingegen in den sich vertikal unterhalb des hinteren Stoßfängers 102 bzw. des Türschwellerbereiches erstreckenden Detektionsbereich 12b hinein. Die Person 80 hat sich beispielhaft dem Fahrzeug 100 im Bereich des hinteren Stoßfängers 102 bzw. der Seitentür genähert. Folglich kann der erste Kapazitätssensor 11 durch das Eindringen des Beines 80.1 in den ersten Detektionsbereich 11b die Annäherung der Person 80 delektieren. Signalisiert die Person die Absicht der Betätigung des beweglichen Teils 101 durch ein Hin- und Herbewegen des Fußes 80.2 in den zweiten Detektionsbereich 12b, so entsteht ein vorgegebenes Bewegungsmuster 60 der Person. Durch die gekoppelte Detektion sowohl des Beines 80.1 als auch des Fußes 80.2 kann die Betätigung der Heckklappe 101 bzw. der Seitentür 101 ausgelöst werden. Ebenfalls kann durch ein nicht dargestelltes Leucht- und/oder Anzeigemittel die entsprechenden Detektionsbereiche 11b, 12b ausgeleuchtet werden. Auch kann der Zustand des beweglichen Teils 101 auf dem Bürgersteig oder der Strasse neben dem Fahrzeug durch eine Schrift angezeigt werden. Bei der Betätigung wird das elektromechanische Schloss 103 derart verstellt, dass es das bewegliche Teil 101 freigibt, wodurch es von einer Schließstellung in eine Offenstellung überführbar ist. Der Öffnungs- und/oder Schließvorgang kann selbst mechanisch durch den in Figur 1 angedeuteten Aufstellmechanismus 104 erfolgen, der ebenfalls durch die Betätigung des virtuellen Schalters aktiviert wird bzw. von dem Sensorsystem 10 erkannt wird.

Figur 3 zeigt in einer Draufsicht die Anordnung der Sensoren 11 und 12 innerhalb des hinteren Stoßfängers 102 des Fahrzeugs 100. Der hintere Stoßfänger 102 erstreckt sich über den gesamten Bereich des Fahrzeughecks 105 des Fahrzeugs 100, wobei der Stoßfänger 102 in der gesamten Breite gezeigt ist. Gemäß der Darstellung ist erkennbar, dass sich die Sensoren 11 und 12 etwa über die gesamten Breite des Stoßfängers 102 hinweg erstrecken können. Folglich kann sich eine Person 80 an einer beliebigen Stelle über dem gesamten Heckbereich 105 des Fahrzeugs 100 nähern und die in Figur 2 beschriebene Bewegung des Beines 80.1 sowie des Fußes 80.2 ausführen.

Die Darstellung zeigt die Anordnung des ersten Kapazitätssensors 11 im horizontalen Bereich des Stoßfängers 102, wohingegen der zweite Kapazitätssensor 12 mit der diesen umschließenden Abschirmung 12.6 im unteren Bereich des Stoßfängers 102 angedeutet ist. Die Kapazitätssensoren 12 können folienartig oder leiterbahnartig über der Breite des Stoßfängers 102 in diesem eingebracht oder verlegt sein. Vorzugsweise werden die Kapazitätssensoren 11 und 12 mit den jeweiligen Abschirmungen 11.6, 12.6 innenseitig im Stoßfänger 102 angeordnet.

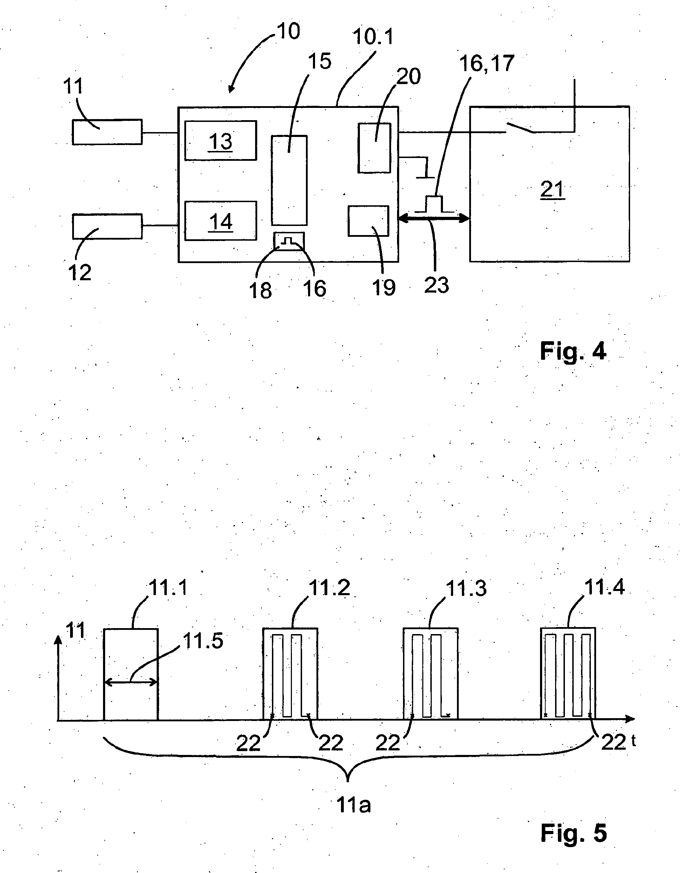

In Figur 4 ist das erfindungsgemäße Sensorsystem 10 für das Fahrzeug 100 schematisch dargestellt. Hierbei sind die beiden Sensoren 11,12 in der Regel nicht in dem Gehäuse 10.1 für das Sensorsystem 10 angeordnet, da sie in der Regel den Außenbereich des Fahrzeugs 100 überwachen. Somit sind die jeweiligen Detektionsbereiche 11b,12b auf den Außenbereich des Fahrzeugs 100 gerichtet. Hierbei können sich die Detektionsbreiche 11b,12b teilweise überlappen oder getrennt voneinander angeordnet sein. Innerhalb des Gehäuses 10.1 des Sensorsystems ist die Steuereinheit 15 mit der Sensorik 13,14 für die Sensoren 11,12 verbunden. Die beiden Sensoren 11,12 können leitungsverbunden sein oder über eine drahtlose Verbindung mit der Steuereinheit 15 bzw. der Sensorik 13,14 verbunden sein. Das Sensorsystem 10 selbst wird über die Spannungsversorgung 20 mit elektrischer Energie versorgt, die vom Fahrzeug 100 her zugeführt wird. Um die Datenkommunikation zwischen dem erfindungsgemäßen Sensorsystem 10 und dem externen Steuermodul 21 zu ermöglichen, ist das Kommunikationssystem 23 vorgesehen, welches insbesondere als LIN- oder CAN-Datenbus ausgestaltet ist. An dieser Stelle sei auch erwähnt, dass selbstverständlich weitere Sensorsysteme 10 oder externe Steuermodule 21 mit dem Kommunikationssystem 23 verbunden sein können. Über das Kommunikationssystem 23 wird das Antwortsignal 17, welches zumindest das letzte Steuersignal 16 umfasst, weitergegeben. Dieses letzte Steuersignal 16 ist in dem dafür vorgesehenen Speicher 18 hinterlegt und wird über die Schnittstelle 19 an das Kommunikationssystem 23 überreicht. Zusätzlich ist das erfindungsgemäße Verfahren in dem Sensorsystem 10 hinterlegt, um die Betriebssicherheit zu verbessern.

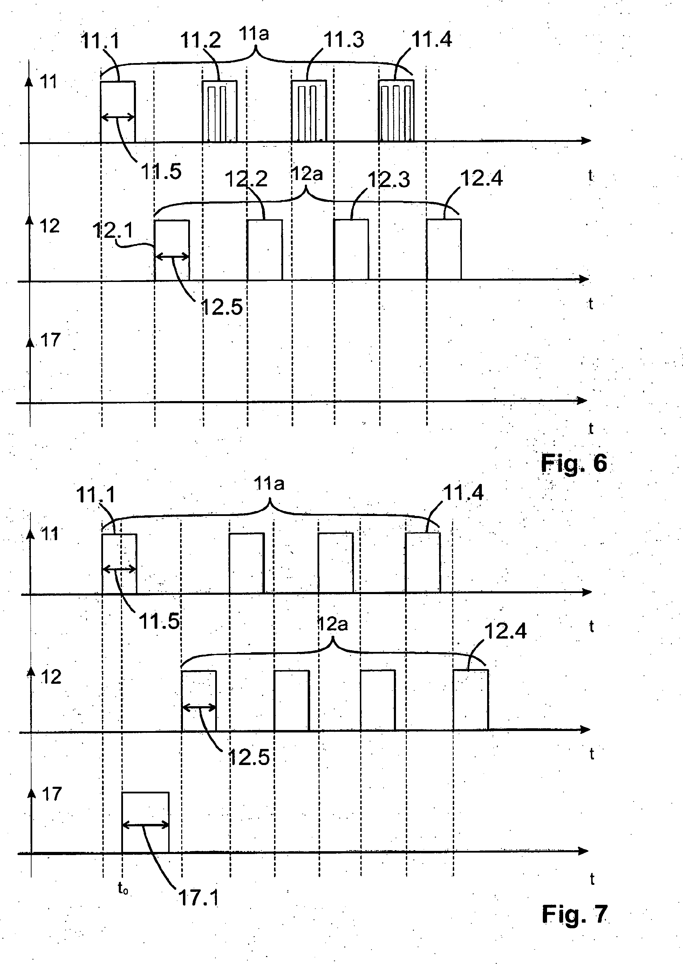

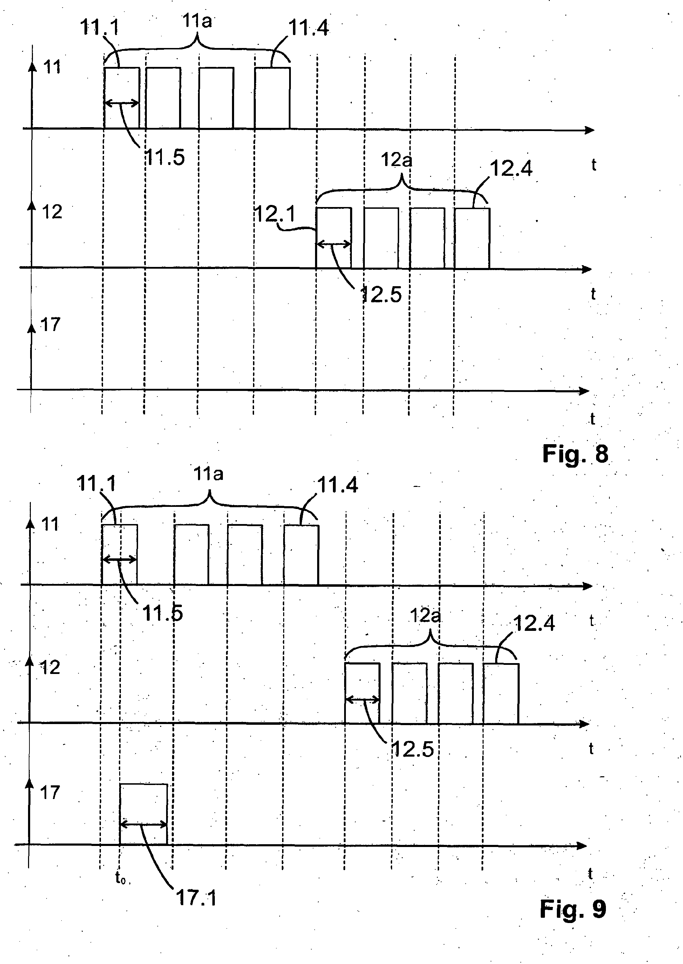

In der weiteren Figur 5 ist ein zeitliches Ablaufdiagramm beispielsweise für die Erfassung des ersten Messsignals 11a vom Sensor 11 dargestellt. Hierbei wird das erste Messsignal 11a in insgesamt vier einzelne Messschritte 11.1-4 zergliedert, die zeitlich hintereinander direkt oder indirekt (mit kurzen Zwischenzeiten) durchgeführt werden. Dabei wird das vollständige Messsignal 11a jeweils an vordefinierten Punkten 22 unterbrochen um z. B. den Messschritt 11.2 zu beenden. Der folgende Messschritt 11.3 beginnt dann an dem vordefinierten Punkt 22, an dem die Messung des Messsignals 11a fortgesetzt wird bis der nächste vordefinierte Punkt 22 folgt. Durch diesen nächsten Punkt 22 wird der Messschritt 11.3 beendet. Im letzten Messschritt 11.4 endet die vollständige Messsignalerfassung, so dass das vollständige Messsignal 11a der Steuereinheit 15 vorliegt. Die Figur 5 dient nur dazu, zu erläutern, wie ein Messsignal 11a in einzelne Messschritte 11.1-4 unterteilt wird. Selbstverständlich können dabei auch wenigere oder mehrere Messschritte vorgenommen werden. Zweckmäßigerweise ist die Zeitspanne 11.5 eines Messschrittes 11.1 kleiner zu wählen als eine Zeitspanne 17.1 des Antwortsignals 17 für das externe Steuermodul 21. In den Figuren 7 und 9 wird dieses näher verdeutlicht.

In der Figur 6 ist ein zeitliches Ablaufdiagramm für die beiden Sensoren 11,12 sowie ein mögliches Antwortsignal 17 dargestellt. Allerdings liegt bei diesem Ablaufdiagramm kein Anforderungssignal von dem externen Steuermodul 21 vor, so dass die Steuereinheit 15 auch tatsächlich kein Antwortsignal 17 übertragen muss. Wie aus der Figur 6 weiter zu entnehmen ist, sind die beiden Messsignale 11a,12a in mehrere Messschritte 11.1-4,12.1-4 unterteilt. Nachdem der erste Messschritt 11.1 von der Steuereinheit 15 erfasst worden ist, wird der nächste Messschritt 12.1 des nächsten Sensors 12 erfasst. Somit werden die Messschritte der einzelnen Sensoren 11,12 alternierend von der Steuereinheit 15 abgefragt. Während des zeitlichen Zwischenraums zwischen der Beendigung des Messschrittes 11.1 und dem Beginn des Messschrittes 12.1 fragt die Steuereinheit 15 die Schnittstelle 19 nach einem Anforderungssignal ab. Sofern dieses Anforderungssignal nicht vorliegt, erfasst die Steuereinheit 15 den folgenden Messschritt.

In der Figur 7 ist im Gegensatz zu Figur 6 jedenfalls ein alternierender Abfrageablauf der Messschritte von den Sensoren 11,12 dargestellt, allerdings liegt hierbei z. B. ein Anforderungssignal zum Zeitpunkt t0 während des ersten Messschrittes 11.1 vor. Nach der Beendigung dieses Messschrittes 11.1 fragt nunmehr die Steuereinheit 15 in dem zeitlichen Zwischenraum die Schnittstelle 19 nach einem vorliegenden Anforderungssignal ab. Da dieses vorliegt, sendet die Steuereinheit 15 umgehend das Antwortsignal 17 über die Schnittstelle 19 an das externe Steuermodul 21. Das externen Steuermodul 21 lässt dem Sensorsystem 10 für das Antwortsignal 17 die Zeitspanne 17.1. Diese Zeitspanne 17.1 beginnt mit der Versendung des Anforderungssignals an das Sensorsystem 10. Wie in der Figur 7 deutlich zu erkennen ist, verschieben sich zeitlich die weiteren Messschritte 11.2-4,12.1-4 von den Sensoren 11,12 bis das Antwortsignal 17 an das externe Steuermodul 21 verschickt worden ist.

In der Figur 8 ist eine Variante zu dem Ablauf aus Figur 6 dargestellt. Hierbei werden die einzelnen Messschritte 11.1-4,12.1-4 nicht alternierend von Sensor 11 zu Sensor 12 abgefragt sondern das Messsignal 11a wird der Reihe nach durch die Messschritte 11.1-4 erfasst. Erst wenn das Messsignal 11a vollständig vorliegt, beginnt die Steuereinheit 15 das Messsignal 12a des weiteren Sensors 12 durch die einzelnen Messschritte 12.1-4 zu erfassen. In der Figur 8 liegt - genauso wie bei Figur 6 - kein Anforderungssignal von dem externen Steuermodul 21 vor.

Im Unterschied zu der Figur 8 sendet beispielsweise das externe Steuermodul 21 ein Anforderungssignal während des ersten Messschrittes 11.1 an das Sensorsystem 10, insbesondere an die Schnittstelle 19. Wie auch in Figur 7 erfasst die Steuereinheit 15 dieses Anforderungssignal von der Schnittstelle 19, welches zwar zum Zeitpunkt t0 von dem externen Steuermodul 21 gesendet worden ist, aber erst nach der Beendigung des ersten Messschrittes 11.1 von der Steuereinheit 15 tatsächlich erfasst wird. Diese sendet daraufhin das Antwortsignal 17 über die Schnittstelle 19 an das externe Steuermodul 21 und zwar innerhalb der zulässigen Zeitspanne 17.1. Da auch in dem Fall von Figur 9 die Zeitspanne 17.1 größer ist als die einzelnen Zeitspannen 11.5, 12.5 der Messschritte 11.1-4,12,1-4, wird sichergestellt, dass das externe Steuermodul 21 auf jeden Fall schnell genug ein Antwortsignal 17 erhält. Dabei sei noch einmal deutlich erwähnt, dass das Antwortsignal 17 zumindest das letzte zwischengespeicherte Steuersignal 16 umfasst, welches der Steuereinheit 15 vorlag. Wie weiter aus der Figur 9 zu erkennen ist, verschieben sich durch das erste übermittelte Antwortsignal 17 die weiteren Messschritte 11.2-4 des ersten Sensors 11 sowie die darauf folgenden Messschritte 12.1-4 vom zweiten Sensor 12. Anschließend kann das erfindungsgemäße Verfahren neu gestartet werden, wobei es aus den letzten vollständigen Messsignalen 11a,12a ein neues Steuersignal 16 generiert wird, welches in den Speicher 18 zwischengespeichert wird.

Abschließend sei noch einmal erwähnt, dass auch mehrere Sensoren durch das erfindungsgemäße Verfahren in dem Sensorsystem 10 eingebunden sein können. Auch können die einzelnen Zeitspannen 11.5,12.5 der Messschritte variieren, wobei es jedoch sinnvoll ist, dass diese nicht die Zeitspanne des Antwortsignals 17 überschreiten.

### Bezugszeichenliste

- 10: Sensorsystem
- 10.1: Gehäuse für 10
- 11: erster Sensor, insbesondere Kapazitätssensor
- 11a: erstes Messsignal
- 11b: erster Detektionsbereich
- 11.1: erster Messschritt
- 11.2: zweiter Messschritt
- 11.3: dritter Messschritt
- 11.4: vierter Messsch ritt
- 11.5: Zeitspanne Messschritt
- 11.6: Richtmittel
- 12: zweiter Sensor, insbesondere Kapazitätssensor
- 12a: zweites Messsignal
- 12b: zweiter Detektionsbereich
- 12.1: erster Messschritt
- 12.2: zweiter Messschritt
- 12.3: dritter Messschritt
- 12.4: vierter Messschritt
- 12.5: Zeitspanne Messschritt
- 12.6: Richtmittel
- 13: Sensorik für 11
- 14: Sensorik für 12
- 115: Steuereinheit, insbesondere Mikroprozessor
- 16: Steuersignal
- 17: Antwortsignal
- 17.1: Zeitspanne des Antwortsignals
- 18: Speicher
- 19: Schnittstelle
- 20: Spannungsversorgung
- 21: externes Steuermodul
- 22: definierter Punkt
- 23: Kommunikationssystem (LIN bzw. CAN-Bus)

- 60: Pfeil für Bewegung von Objekt
- 80: Objekt
- 80.1: Bein
- 80.2: Fuß
- 100: Fahrzeug
- 101: bewegliches Teil, insbesondere Tür, Heckklappe oder dergleichen
- 102: Stossstange
- 103: Schloss
- 104: Aufstellmechanismus
- 105: Fahrzeugheck

## Patentansprüche

1. Verfahren zur Steuerung eines Sensorsystems (10) für ein Fahrzeug (100) mit
zumindest einem bzw. zwei Sensoren (11,12), die jeweils Detektionsbereiche (11b,12b) aufweisen und Änderungen in diesen Detektionsbereichen (11b,12b) messtechnisch erfassen und als Messsignale (11a,12a) weitergeben,
einer Steuereinheit (15), insbesondere in Form eines Mikroprozessors, die mit den Sensoren (11,12) verbunden ist, wobei die Steuereinheit (15) die jeweiligen Messsignale (11a,12a) auswertet und daraus zumindest ein Steuersignal (16) generiert, wenigstens einem Speicher (18), in dem zumindest das letzte Steuersignal (16) gespeichert wird,
einer Schnittstelle (19), womit die Steuereinheit (15) zumindest das letzte Steuersignal an ein externes Steuermodul (21) weiterleitet,
**dadurch gekennzeichnet,**
**dass** zumindest ein Messsignal (11a,12a) eines Sensors (11,12) in mehreren Messschritten (11.1-4,12.1-4) unterteilt und von der Steuereinheit (15) erfasst wird, und dass die Steuereinheit (15) zwischen den einzelnen Messschritten (11.1-4,12.1-4) zumindest das letzte Steuersignal (16) über die Schnittstelle (19) an das externe Steuermodul (21) sendet, wobei die Steuereinheit (15) nach einem bzw. nach jedem Messschritt (11.1-4,12.1-4) überprüft, ob der Schnittstelle (19) ein Anforderungssignal des externen Steuermoduls (21) für ein Antwortsignal (17) vorliegt.

2. Verfahren nach Anspruch 1,
**dadurch gekennzeichnet,**
**dass** jedes Messsignal (11a,12a) der Sensoren (11,12) in einzelne Messschritte (11.1-4,12.1-4) unterteilt wird, die von der Steuereinheit (15) erfasst werden.

3. Verfahren nach Anspruch 1 oder 2,
**dadurch gekennzeichnet,**
**dass** einzelnen Messschritte (11.1-4,12.1-4) der jeweiligen Sensoren (11,12) immer in einer vordefinierten Reihenfolge von der Steuereinheit (15) erfasst werden, so dass die Steuereinheit (15) die Sensoren (11,12) der Reihe nach abfragt.

4. Verfahren nach einem der vorhergehenden Ansprüche,
**dadurch gekennzeichnet,**
**dass** ein Messschritt (11.1-4,12.1-4) an einem definierten Punkt (22) des Messsignales (11a,12a) beendet wird und insbesondere beim folgenden Messschritt (11.1-4,12.1-4) an diesem definierten Punkt (22) die Auswertung fortgesetzt wird.

5. Verfahren nach einem der vorhergehenden Ansprüche,
**dadurch gekennzeichnet,**
**dass** die Zeitspanne (11.5,12.5) für einen Messschritt (11.1-4,12.1-4) kleiner ist als eine vorgegebene Antwortzeitspanne (17.1) von dem externen Steuermodul (21).

6. Verfahren nach einem der vorhergehenden Ansprüche,
**dadurch gekennzeichnet,**
**dass** die Zeitspanne (11.5,12.5) der Messschritte (11.1-4,12.1-4) für alle Sensoren (11,12) gleichlang ist.

7. Verfahren nach einem der vorhergehenden Ansprüche,
**dadurch gekennzeichnet,**
**dass** die Steuereinheit (15) ein Messsignal (11a,12a) aus den einzelnen Messschritten (11.1-4,12.1-4) eines Sensors (11,12) generiert, wenn alle Messschritten (11.1-4,12.1-4) hierfür durchgeführt worden sind, und - dass aus den vollständigen Messsignalen (11a,12a) von der Steuereinheit (15) zumindest ein Steuersignal (16) generiert wird, welches in den Speicher (18) als letztes Steuersignal (16) für ein Antwortsignal (17) an das externe Steuermodul (21) geschoben wird.

8. Verfahren nach einem der vorhergehenden Ansprüche,
**dadurch gekennzeichnet,**
**dass** die Steuereinheit (15) immer nur einen Aktor, insbesondere in Form der Sensoren (11,12) oder der Schnittstelle (19), gleichzeitig abfragen bzw. erfassen kann.

9. Verfahren nach einem der vorhergehenden Ansprüche,
**dadurch gekennzeichnet,**
**dass** eine bidirektionale Datenübertragung, insbesondere serielle Datenübertragung, über die Schnittstelle (19) mit dem externen Steuermodul (21) erfolgt.

10. Verfahren nach einem der vorhergehenden Ansprüche,
**dadurch gekennzeichnet,**
**dass** die Schnittstelle (19) der Steuereinheit (15) das Steuersignal (16) als Antwortsignal (17) an ein insbesondere serielles Kommunikationssystem (23), insbesondere ein sogenanntes Local Interconnect Network (LIN-Bus) oder ein Controller Area Network (CAN-Bus), weitergibt.

11. Sensorsystem (10) für ein Fahrzeug (100) mit
zumindest zwei Sensoren (11,12), die jeweils Detektionsbereiche (11b,12b) aufweisen und Änderungen in diesen Detektionsbereichen (11b,12b) messtechnisch erfassen und als Messsignale (11a, 12a) weitergeben,
einer Steuereinheit (15), insbesondere in Form eines Mikroprozessors, die mit den Sensoren (11,12) verbunden ist, wobei die Steuereinheit (15) die jeweiligen Messsignale (11a,12a) auswertet und daraus zumindest ein Steuersignal (16) generiert, wenigstens einem Speicher (18), in dem zumindest das letzte Steuersignal (16) speicherbar ist,
einer Schnittstelle (19), womit die Steuereinheit (15) zumindest das letzte Steuersignal an ein externes Steuermodul (21) weiterleitet,
**dadurch gekennzeichnet,**
**dass** in der Steuereinheit (15) ein Verfahren nach einem der vorhergehenden Ansprüche abläuft.

12. Sensorsystem (10) nach Anspruch 11,
**dadurch gekennzeichnet,**
**dass** die Steuereinheit (15) genau einen Mikroprozessor aufweist.

## Claims

1. A method for controlling a sensor system (10) for a vehicle (100) with
at least one or two sensors (11, 12), each of which comprises detection areas (11b, 12b) and records changes in these detection areas (11b, 12b) by taking measurements, and forwards these measurements as measuring signals (11a, 12a),
a control unit (15), in particular in the form of a microprocessor connected with the sensors (11, 12), wherein the control unit (15) evaluates the respective measuring signals (11a, 12a) and generates therefrom at least one control signal (16),
at least one memory (18), in which at least the last control signal (16) is stored,
an interface (19) via which the control unit (15) forwards at least the last control signal to an external control module (21),
**characterised in that**
at least one measuring signal (11a, 12a) of a sensor (11, 12) is divided into several measuring steps (11.1-4, 12.1-4) and recorded by the control unit (15); and
**in that** the control unit (15), between individual measuring steps (11.1-4, 12.1-4), sends at least the last control signal (16) via the interface (19) to the external control module (21), wherein the control unit (15), after one or each measuring step (11.1-4, 12.1-4), checks whether a request signal from the external control module (21) for a response signal (17) is present at the interface (19).

2. The method according to claim 1,
**characterised in that**
each measuring signal (11a, 12a) of the sensors (11, 12) is divided into individual measuring steps (11.1-4, 12.1-4) which are recorded by the control unit (15).

3. The method according to claim 1 or 2,
**characterised in that**
individual measuring steps (11.1-4, 12.1-4) of the respective sensors (11, 12) are always recorded by the control unit (15) in a predefined sequence so that the control unit (15) polls the sensors (11, 12) one after the other.

4. The method according to one of the preceding claims,
**characterised in that**
one measuring step (11.1-4, 12.1-4) is terminated at a defined point (22) of the measuring signal (11a, 12a) and that in particular evaluation is continued as from this defined point (22) during the following measuring step (11.1-4, 12.1-4).

5. The method according to one of the preceding claims,
**characterised in that**
the time span (11.5, 12.5) for one measuring step (11.1-4, 12.1-4) is smaller than a predefined response time span (17.1) from the external control module (21).

6. The method according to one of the preceding claims,
**characterised in that**
time span (11.5, 12.5) of the measuring steps (11.1-4, 12.1-4) is of equal length for all sensors (11, 12).

7. The method according to one of the preceding claims,
**characterised in that**
the control unit (15) generates a measuring signal (11a, 12a) from the individual measuring steps (11.1-4, 12.1-4) of one sensor (11, 12), after all measuring steps (11.1-4, 12.1-4) for this have been carried out, and
that at least one control signal (16) is generated by the control unit (15) from the complete measuring signals (11a, 12a), which signal is moved into the memory (18) as the last control signal (16) for a response signal (17) to the external control module (21).

8. The method according to one of the preceding claims,
**characterised in that**
the control unit (15) is only able, at any one time, to simultaneously poll or record one actuator, in particular in the form of sensors (11, 12) or the interface (19).

9. The method according to one of the preceding claims,
**characterised in that**
a bi-directional data transmission, in particular a serial data transmission, takes place via the interface (19) with the external control module (21).

10. The method according to one of the preceding claims,
**characterised in that**
the interface (19) of the control unit (15) forwards the control signal (16) as a response signal (17) to an, in particular, serial communication system (23), in particular a so-called local interconnect network (LIN bus) or a controller area network (CAN bus).

11. A sensor system (10) for a vehicle (100) with
at least one or two sensors (11, 12), each of which comprises detection areas (11b, 12b) and records changes in these detection areas (11b, 12b) by taking measurements, and forwards these measurements as measuring signals (11a, 12a),
a control unit (15), in particular in the form of a microprocessor, connected with the sensors (11, 12), wherein the control unit (15) evaluates the respective measuring signals (11a, 12a) and generates therefrom at least one control signal (16),
at least one memory (18) in which at least the last control signal (16) can be stored, an interface (19) via which the control unit (15) forwards at least the last control signal to an external control module (21),
**characterised in that**
a method according to one of the preceding claims runs in the control unit (15).

12. The sensor system (10) according to claim 11,
**characterised in that**
that the control unit (15) comprises exactly one microprocessor.

## Revendications

1. Procédé de commande d'un système de capteurs (10) pour un véhicule (100) comprenant
au moins un ou deux capteurs (11, 12) qui présentent des zones de détection (11b, 12b) respectives et détectent des changements dans ces zones de détection (11 b, 12b) par une technique de mesure et les transmettent en tant que signaux de mesure (11a, 12a), une unité de commande (15), en particulier sous la forme d'un microprocesseur, qui est reliée aux capteurs (11, 12), l'unité de commande (15) évaluant les signaux de mesure (11a, 12a) respectifs et générant à partir de ceux-ci au moins un signal de commande (16),
au moins une mémoire (18) dans laquelle au moins le dernier signal de commande (16) est mémorisé,
une interface (19), au moyen de laquelle l'unité de commande (15) transmet au moins le dernier signal de commande à un module de commande externe (21),
**caractérisé en ce**
**qu'**au moins un signal de mesure (11a, 12a) d'un capteur (11, 12) est divisé en plusieurs étapes de mesure (11.1-4, 12.1-4) et détecté par l'unité de commande (15), et
**que** l'unité de commande (15) envoie entre les étapes de mesure individuelles (11.1-4, 12.1-4) au moins le dernier signal de commande (16) au module de commande externe (21) via l'interface (19), l'unité de commande (15) vérifiant après une ou après chaque étape de mesure (11.1-4, 12.1-4) si un signal de demande du module de commande externe (21) pour un signal de réponse (17) est présent à l'interface (19).

2. Procédé selon la revendication 1,
**caractérisé en ce**
**que** chaque signal de mesure (11a, 12a) des capteurs (11, 12) est divisé en étapes de mesure individuelles (11.1-4, 12.1-4) qui sont détectées par l'unité de commande (15).

3. Procédé selon la revendication 1 ou 2,
**caractérisé en ce**
**que** les étapes de mesure individuelles (11.1-4, 12.1-4) des capteurs (11, 12) respectifs sont toujours détectées dans un ordre prédéfini par l'unité de commande (15), de sorte que l'unité de commande (15) interroge les capteurs (11, 12) l'un après l'autre.

4. Procédé selon l'une des revendications précédentes,
**caractérisé en ce**
**qu'**une étape de mesure (11.1-4, 12.1-4) se termine à un point défini (22) du signal de mesure (11a, 12a) et qu'en particulier à l'étape de mesure (11.1-4, 12.1-4) suivante, l'évaluation reprend à ce point défini (22).

5. Procédé selon l'une des revendications précédentes,
**caractérisé en ce**
**que** l'intervalle de temps (11.5, 12.5) pour une étape de mesure (11.1-4, 12.1-4) est plus petit qu'un intervalle de temps de réponse prédéfini (17.1) du module de commande externe (21).

6. Procédé selon l'une des revendications précédentes,
**caractérisé en ce**
**que** l'intervalle de temps (11.5, 12.5) des étapes de mesure (11.1-4, 12.1-4) est de même longueur pour tous les capteurs (11, 12).

7. Procédé selon l'une des revendications précédentes,
**caractérisé en ce**
**que** l'unité de commande (15) génère un signal de mesure (11a, 12a) à partir des étapes de mesure individuelles (11.1-4, 12.1-4) d'un capteur (11, 12) lorsque toutes les étapes de mesure (11.1-4, 12.1-4) nécessaires à cet effet ont été effectuées, et
**qu'**au moins un signal de commande (16) est généré par l'unité de commande (15) à partir des signaux de mesure (11a, 12a) complets, lequel est placé dans la mémoire (18) en tant que dernier signal de commande (16) pour un signal de réponse (17) au module de commande externe (21).

8. Procédé selon l'une des revendications précédentes,
**caractérisé en ce**
**que** l'unité de commande (15) peut toujours interroger ou détecter un seul actionneur à la fois, en particulier sous la forme des capteurs (11, 12) ou de l'interface (19).

9. Procédé selon l'une des revendications précédentes,
**caractérisé en ce**
**qu'**une transmission de données bidirectionnelle, en particulier en série, a lieu via l'interface (19) avec le module de commande externe (21).

10. Procédé selon l'une des revendications précédentes,
**caractérisé en ce**
**que** l'interface (19) de l'unité de commande (15) transmet le signal de commande (16) en tant que signal de réponse (17) à un système de communication (23) en particulier série, en particulier un « Local Interconnect Network » (bus LIN) ou un « Controller Area Network » (bus CAN).

11. Système de capteurs (10) pour un véhicule (100) comprenant
au moins deux capteurs (11, 12) qui présentent des zones de détection (11b, 12b) respectives et détectent des changements dans ces zones de détection (11b, 12b) par une technique de mesure et les transmettent en tant que signaux de mesure (11a, 12a), une unité de commande (15), en particulier sous la forme d'un microprocesseur, qui est reliée aux capteurs (11, 12), l'unité de commande (15) évaluant les signaux de mesure (11a, 12a) respectifs et générant à partir de ceux-ci au moins un signal de commande (16),
au moins une mémoire (18) dans laquelle au moins le dernier signal de commande (16) peut être mémorisé,
une interface (19), au moyen de laquelle l'unité de commande (15) transmet au moins le dernier signal de commande à un module de commande externe (21),
**caractérisé en ce**
**qu'**un procédé selon l'une des revendications précédentes est mis en oeuvre dans l'unité de commande (15).

12. Système de capteurs (10) selon la revendication 11,
**caractérisé en ce**
**que** l'unité de commande (15) présente exactement un microprocesseur.
